# EUROPEAN PATENT APPLICATION

(11) **EP 4 827 254 A1**
(43) Date of publication of application: **21.10.2026**
(21) Application number: 26172266.4
(22) Date of filing: 14.04.2026
(51) Int. Cl.: H05K 7/14, H05K 7/20

(54) **DEPLOYABLE DATA CENTER COOLING SYSTEM**

(30) Priority: 14.04.2025 US 202563788640 P; 22.01.2026 US 202619457135
(71) Applicant: Vertiv Corporation, Westerville, OH 43082 (US)
(72) Inventor: BUSCH, Gregory Thomas, Westerville, 43082 (US); FALLAHTAFTI, Najmeh, Westerville, 43082 (US); KUNDU, Arpan, Westerville, 43082 (US); SCHRADER, Timothy James, Westerville, 43082 (US)
(74) Representative: Beal, James Michael

(57) **Abstract**

A deployable data center system can include a container and a plurality of cooling units for rejecting heat from a cooling fluid to an environment outside of the container. The cooling units can be disposed in the container when in a storage configuration. The cooling units can be transformed from the storage configuration to a deployed configuration, in which the cooling units can be exposed to the environment outside of the container. One or more servers and/or evaporators can be disposed in one portion of the container and the cooling units can be disposed in another portion of the container.

## Description

### CROSS-REFERENCE TO RELATED APPLICATION(S)

This application claims the benefit of U.S. Provisional Patent Application No. 63/788,640 filed April 14, 2025, and of U.S. Non-Provisional Patent Application No. 19/457,135 filed January 22, 2026.

### TECHNICAL FIELD

The present disclosure relates generally to data centers and more specifically relates to cooling systems for data centers.

### BACKGROUND

As data center services see increasingly widespread demand, there is a growing desire to rapidly deploy data centers to remote locations. Recent advances in server technology have allowed increasing Information Technology (IT) performance in limited footprints, such as standardized shipping containers. Such increases in IT performance density necessarily increase power density, thereby increasing the heat density generated by the IT equipment. This heat must be rejected from the data center. However, current cooling systems for rapidly deployable data centers are unable to adequately reject the increased heat without significantly increasing the space requirements and/or otherwise complicating rapid deployment of the data centers.

### SUMMARY

Applicant has created new and useful devices, systems and methods for data center cooling systems. Deployable data centers are needed to provide IT capabilities quickly and/or in remote locations, but the capabilities of such data centers are limited by their cooling requirements and space constraints, for both the IT equipment and cooling systems. Data centers according to the disclosure can advantageously enable sufficient cooling for IT equipment in a modular data center format, enable data center customers to more fully exploit advances in server technology in many areas of the world, reduce data center construction costs, reduce data center deployment timelines, and accelerate/increase data center profitability. In at least one embodiment, a data center according to the disclosure can include cooling units that can be readily deployed from the same standardized shipping container that also contains data center servers and/or other IT equipment.

In at least one embodiment, a deployable data center system according to the disclosure can include a container, one or more servers disposed in the container, at least one evaporator disposed in the container for transferring heat from the servers to a cooling fluid, a plurality of cooling units for rejecting heat from the cooling fluid to an environment outside of the container, or any combination thereof. In at least one embodiment, the container can have a first portion, a second portion and/or one or more other portions. In at least one embodiment, the servers and/or the evaporator can be disposed in the first portion of the container. In at least one embodiment, the cooling units can transform from a storage configuration to a deployed configuration. In at least one embodiment, the cooling units can be disposed within the second portion of the container and/or isolated from the environment, when in the storage configuration. In at least one embodiment, the cooling units can be exposed to the environment outside of the container, when in the deployed configuration.

In at least one embodiment, the container can be or include a standardized shipping container, such as those meeting ISO 668 promulgated by the International Organization for Standardization (ISO). For example, in at least one embodiment, the container can be 8 feet wide and either 40 feet or 45 feet long.

In at least one embodiment, the evaporator can be or include one or more air-to-fluid heat exchangers for extracting heat from air within the container, such as the first portion of the container. In at least one embodiment, the evaporator can be or include one or more direct-to-chip heat exchangers thermally coupled to the one or more of the servers. In at least one embodiment, the evaporator can include one or more fluid-to-fluid heat exchangers, such as brazed plate heat exchangers (BPHE), for extracting heat from the one or more direct-to-chip heat exchangers, such as through the cooling fluid and/or another cooling fluid.

In at least one embodiment, the plurality of cooling units can include one, two, or more rows of cooling units. In at least one embodiment, any or all of the cooling units can include at least one heat exchanger and at least one fan. In at least one embodiment, each row of cooling units can be or include at least one heat exchanger and a row of fans. For example, in at least one embodiment, each row of cooling units can include a row of heat exchangers and a row of fans, such as above the heat exchangers. In at least one embodiment, the cooling units can be or include condensers, dry coolers, cooling towers, or any combination thereof.

In at least one embodiment, any or all of the cooling units can hingedly rotate and/or slide (horizontally and/or vertically) between the storage configuration and the deployed configuration. In at least one embodiment, a first portion of the cooling units can hingedly rotate between the storage configuration and the deployed configuration and a second portion of the cooling units can slide between the storage configuration and the deployed configuration. In at least one embodiment, a first row of cooling units can hingedly rotate in a first direction between the storage configuration and the deployed configuration and a second row of cooling units can hingedly rotate in a second direction between the storage configuration and the deployed configuration.

In at least one embodiment, the cooling units can be disposed within a footprint of the container when in the storage configuration. In at least one embodiment, any or all of the cooling units can remain within the footprint of the container when in the deployed configuration and/or any or all of the cooling units can extend beyond the footprint of the container when in the deployed configuration. In at least one embodiment, a first portion of the cooling units can remain within a footprint of the container when in the deployed configuration and a second portion of the cooling units hingedly rotate between the storage configuration and the deployed configuration, in which any or all of the second portion of the cooling units can remain within the footprint of the container and/or extend beyond the footprint of the container. In at least one embodiment, a deployed footprint of the cooling units in the deployed configuration can be larger than a storage footprint of the cooling units in the storage configuration. In at least one embodiment, the deployed footprint of the cooling units in the deployed configuration can be twice the storage footprint of the cooling units in the storage configuration.

In at least one embodiment, the cooling units need not be disconnected from the evaporator, once fluidically coupled thereto. In at least one embodiment, the cooling units can remain fluidically coupled to the evaporator when in the storage configuration, when in the deployed configuration, while transforming from the storage configuration to the deployed configuration, or any combination thereof. In at least one embodiment, the cooling units can be fluidically coupled to the evaporator through one or more flexible segments, such as one or more hoses, and/or one or more rotating joints.

In at least one embodiment, a deployable data center system according to the disclosure can include one or more containers, and each container can include a plurality of cooling units configured to selectively reject heat from a cooling fluid to an environment outside of the container. The plurality of cooling units can be transformable from a storage configuration to a deployed configuration. The plurality of cooling units can be disposed within the container when in the storage configuration, and can be exposed to the environment outside of the container when in the deployed configuration.

A method for deploying a data center according to the disclosure can include fluidically coupling one or more cooling units to one or more evaporators disposed within a container and testing functionality and/or integrity of the cooling units, while the cooling units are in a deployed configuration, and transforming the cooling units from the deployed configuration to a storage configuration, while the cooling units remain fluidically coupled to the evaporator. In at least one embodiment, the cooling units can be disposed within the container when in the storage configuration and/or exposed to an environment outside the container when in the deployed configuration. In at least one embodiment, the method can include transforming the cooling units from the storage configuration to the deployed configuration, while the cooling units remain fluidically coupled to the evaporator. In at least one embodiment, transforming the cooling units from the storage configuration to the deployed configuration can include moving at least some of the cooling units from within a footprint of the container to outside the footprint of the container.

In at least one embodiment, the method can include enclosing the cooling units within the container, while in the storage configuration, and/or moving the container to an installation location while the cooling units are in the storage configuration and/or enclosed in the container. In at least one embodiment, the method can include, such as after moving the container to the installation location, opening at least a portion of the container while the cooling units are in the storage configuration.

### BRIEF DESCRIPTION OF THE DRAWINGS

FIG. 1 is an elevation view of one of many embodiments of a cooling unit according to the disclosure.
FIG. 2 is a perspective view of one of many embodiments of a deployable data center system according to the disclosure.
FIG. 3 is a simplified diagram of one of many embodiments of a deployable data center system according to the disclosure.
FIG. 4 is a perspective view of one of many embodiments of a deployable data center system according to the disclosure, in a stowed configuration.
FIG. 5 is a perspective view of the embodiment of FIG. 4, with certain panels removed.
FIG. 6 is a perspective view of the embodiment of FIG. 4, with certain panels folded out.
FIG. 7 is a perspective view of the embodiment of FIG. 4, with certain arrays elevated.
FIG. 8 is a perspective view of one of many embodiments of a deployable data center system according to the disclosure, with certain panels folded out.
FIG. 9 is a perspective view of the embodiment of FIG. 8, with certain arrays folded out.
FIG. 10 is a perspective view of one of many embodiments of a deployable data center system according to the disclosure, with certain panels removed.
FIG. 11 is a perspective view of the embodiment of FIG. 10, with certain panels and arrays folded out.
FIG. 12 is a perspective view of one of many embodiments of a deployable data center system according to the disclosure, with certain panels folded out.
FIG. 13 is a perspective view of the embodiment of FIG. 13, in another stage of deployment.
FIG. 14 is a perspective view of the embodiment of FIG. 13, in another stage of deployment.
FIG. 15 is a perspective view of one of many embodiments of a deployable data center system according to the disclosure, with certain panels folded out.
FIG. 16 is a perspective view of the embodiment of FIG. 15, in another stage of deployment.
FIG. 17 is a perspective view of the embodiment of FIG. 15, in another stage of deployment.
FIG. 18 is a perspective view of one of many embodiments of a deployable data center system according to the disclosure, with certain panels folded out.
FIG. 19 is a perspective view of the embodiment of FIG. 18, in another stage of deployment.
FIG. 20 is a perspective view of the embodiment of FIG. 18, in another stage of deployment.
FIG. 21 is a simplified diagram of one of many embodiments of a deployable data center system according to the disclosure, deployed adjacent to a building.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others. As used herein, relational terms such as "first," "second," and the like are merely used as arbitrary identifiers for ease of reference and understanding and are not intended to limit the scope of the disclosure or claims unless otherwise indicated.

Any process flowcharts discussed herein illustrate the operation of possible implementations of systems and methods according to various embodiments of the present disclosure. Each block in a flowchart may represent a module, segment, or portion of one or more of such implementations. In some implementations, the subject matter noted in the block(s) might occur out of the order depicted in the figures. For example, blocks shown in succession may, in fact, be executed substantially concurrently.

Applicant has created new and useful devices, systems and methods for data center cooling systems. Deployable data centers are needed to provide IT capabilities quickly and/or in remote locations, but the capabilities of such data centers are limited by their cooling requirements and space constraints, for both the IT equipment and cooling systems. Data centers according to the disclosure can advantageously enable sufficient cooling for IT equipment in a modular data center format, enable data center customers to more fully exploit advances in server technology in many areas of the world, reduce data center construction costs, reduce data center deployment timelines, and accelerate/increase data center profitability. In at least one embodiment, a data center according to the disclosure can include cooling units that can be readily deployed from the same standardized shipping container that also contains data center servers and/or other IT equipment.

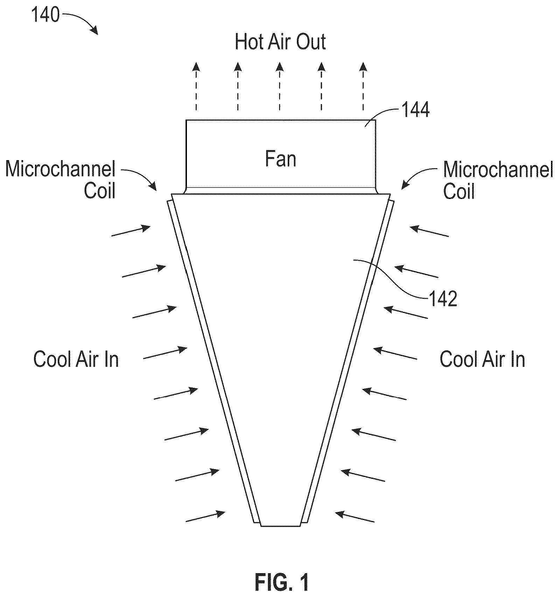

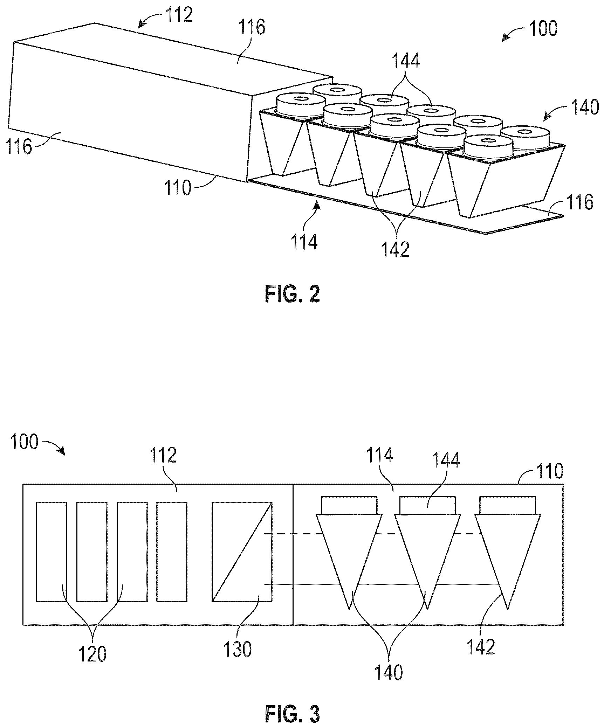

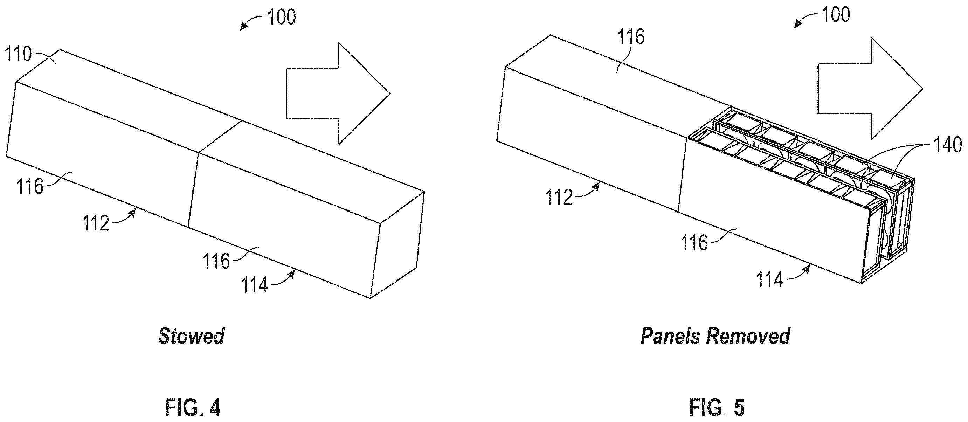

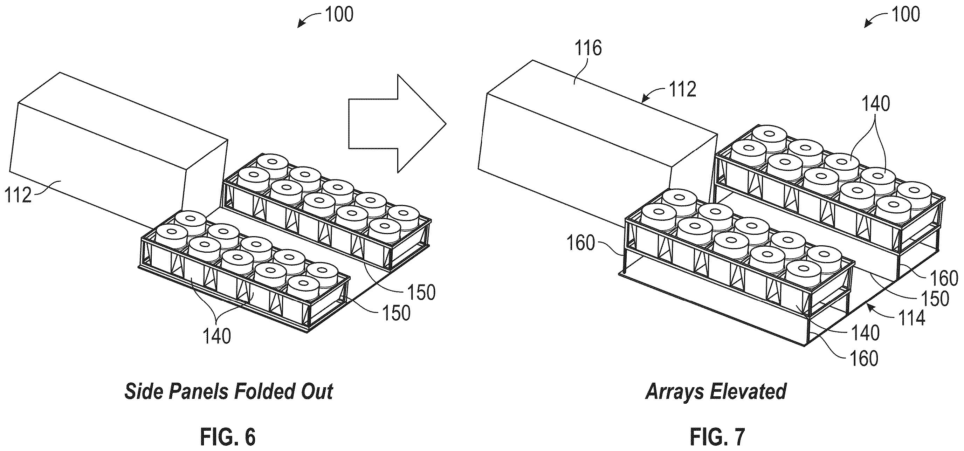

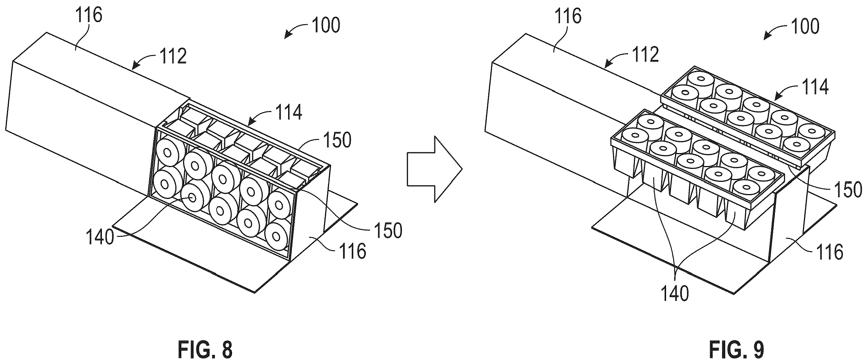

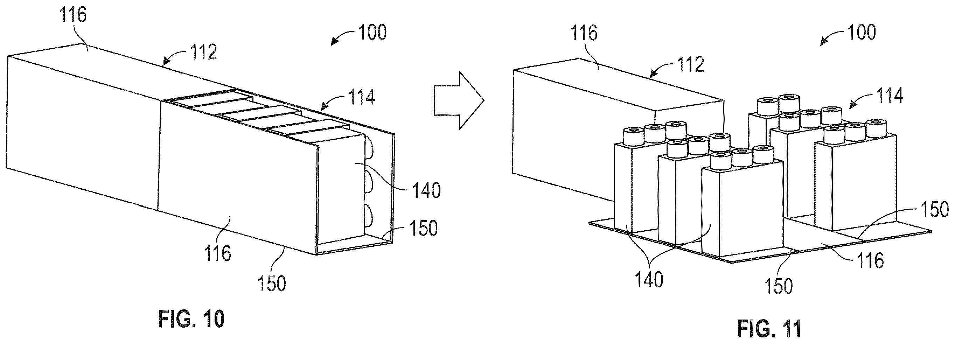

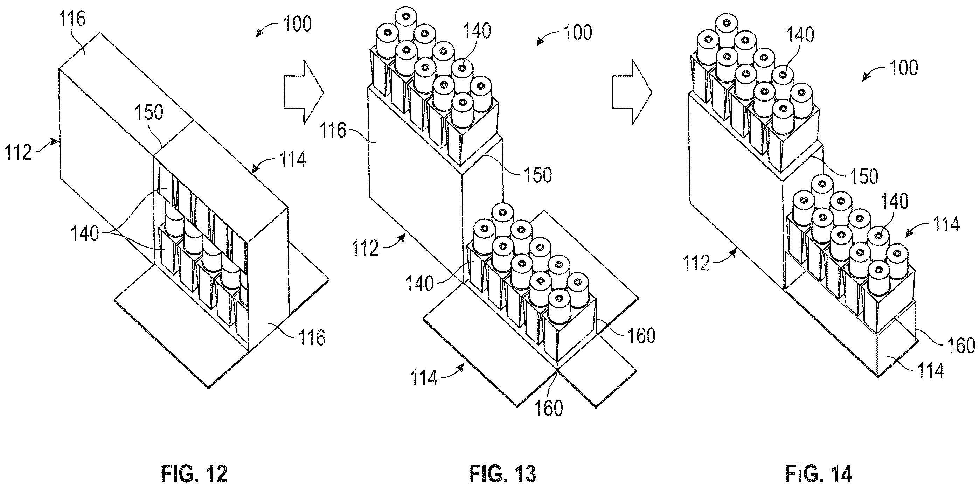

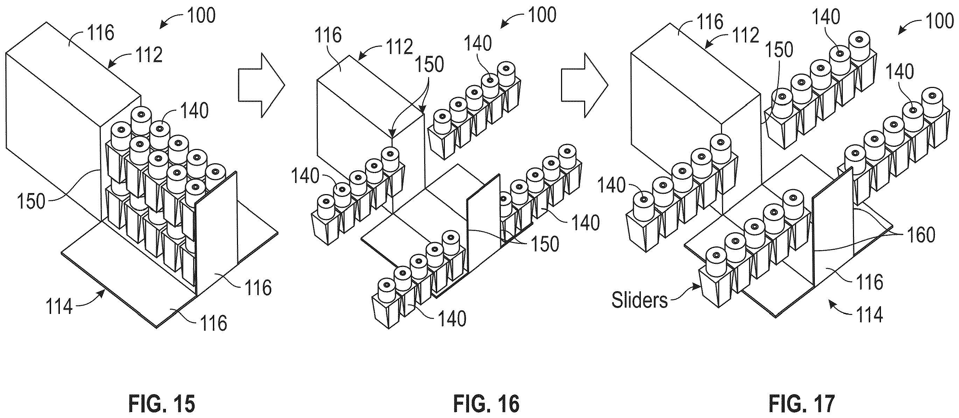

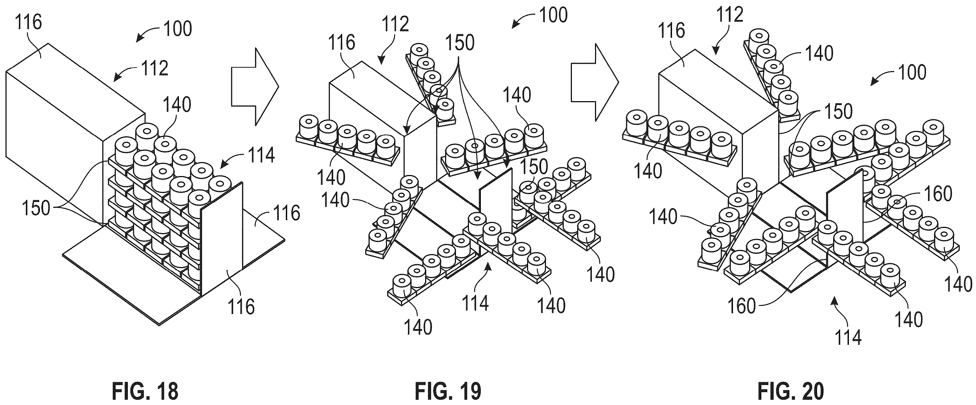

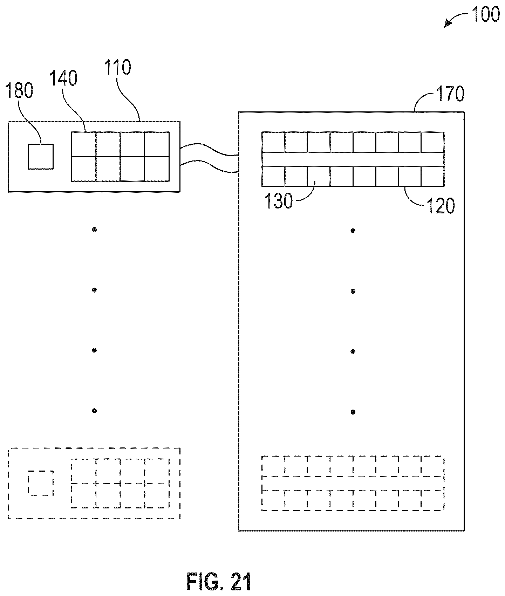

FIG. 1 is an elevation view of one of many embodiments of a cooling unit according to the disclosure. FIG. 2 is a perspective view of one of many embodiments of a deployable data center system according to the disclosure. FIG. 3 is a simplified diagram of one of many embodiments of a deployable data center system according to the disclosure. FIG. 4 is a perspective view of one of many embodiments of a deployable data center system according to the disclosure, in a stowed configuration. FIG. 5 is a perspective view of the embodiment of FIG. 4, with certain panels removed. FIG. 6 is a perspective view of the embodiment of FIG. 4, with certain panels folded out. FIG. 7 is a perspective view of the embodiment of FIG. 4, with certain arrays elevated. FIG. 8 is a perspective view of one of many embodiments of a deployable data center system according to the disclosure, with certain panels folded out. FIG. 9 is a perspective view of the embodiment of FIG. 8, with certain arrays folded out. FIG. 10 is a perspective view of one of many embodiments of a deployable data center system according to the disclosure, with certain panels removed. FIG. 11 is a perspective view of the embodiment of FIG. 10, with certain panels and arrays folded out. FIG. 12 is a perspective view of one of many embodiments of a deployable data center system according to the disclosure, with certain panels folded out. FIG. 13 is a perspective view of the embodiment of FIG. 13, in another stage of deployment. FIG. 14 is a perspective view of the embodiment of FIG. 13, in another stage of deployment. FIG. 15 is a perspective view of one of many embodiments of a deployable data center system according to the disclosure, with certain panels folded out. FIG. 16 is a perspective view of the embodiment of FIG. 15, in another stage of deployment. FIG. 17 is a perspective view of the embodiment of FIG. 15, in another stage of deployment. FIG. 18 is a perspective view of one of many embodiments of a deployable data center system according to the disclosure, with certain panels folded out. FIG. 19 is a perspective view of the embodiment of FIG. 18, in another stage of deployment. FIG. 20 is a perspective view of the embodiment of FIG. 18, in another stage of deployment. FIG. 21 is a simplified diagram of one of many embodiments of a deployable data center system according to the disclosure, deployed adjacent to a building. FIGS. 1-21 are described in conjunction with one another.

In at least one embodiment, a deployable data center system 100 according to the disclosure can include one or more containers 110, one or more servers 120 disposed in the container 110, one or more evaporators 130 disposed in the container 110 for transferring heat from the servers 120 to a cooling fluid, one or more cooling units 140 for rejecting heat from the cooling fluid to an environment outside of the container 110, or any combination thereof. In at least one embodiment, the container 110 can have a plurality of sections or portions, such as a first portion 112 and a second portion 114, and/or one or more other portions. In at least one embodiment, the servers 120 and/or the evaporator 130 can be disposed in the first portion 112 of the container 110. In at least one embodiment, the cooling units 140 can transform from a storage configuration to a deployed configuration. In at least one embodiment, the cooling units 140 can be disposed within the second portion 114 of the container 110 and/or isolated from the environment, when in the storage configuration. In at least one embodiment, the cooling units 140 can be exposed to the environment outside of the container 110, when in the deployed configuration. The term "server(s)" is used broadly herein and can be or include other actively cooled IT equipment, e.g., one or more computer processing units (CPUs) and/or graphics processing units (GPUs).

In at least one embodiment, the container 110 can be or include a standardized shipping container, such as those meeting ISO 668 promulgated by the International Organization for Standardization (ISO). For example, in at least one embodiment, the container 110 can be 8 feet wide and either 40 feet or 45 feet long. As another example, in at least one embodiment, the container 110 can be at least 7 feet wide and at least 35 feet long. In at least one embodiment, the container 110, or the first portion 112 thereof, can house Information Technology (IT) equipment with 1 MW of power, or more, and/or liquid cooling equipment such as heat exchangers, pumps, manifolds, plumbing, fluid control components, or any combination thereof.

In at least one embodiment, the evaporator 130 can be or include one or more air-to-fluid heat exchangers for extracting heat from air within the container 110, such as the first portion 112 of the container 110. In at least one embodiment, the evaporator 130 can be or include one or more direct-to-chip heat exchangers thermally coupled to the one or more of the servers 120. In at least one embodiment, the evaporator 130 can include one or more fluid-to-fluid heat exchangers, such as brazed plate heat exchangers (BPHE), for extracting heat from the one or more direct-to-chip heat exchangers, such as through the cooling fluid and/or another cooling fluid.

In at least one embodiment, the cooling units 140 can include one, two, or more rows of cooling units 140. In at least one embodiment, any or all of the cooling units 140 can include at least one heat exchanger 142 and at least one fan 144. In at least one embodiment, each row of cooling units 140 can be or include at least one heat exchanger 142 and a row of fans 144. For example, in at least one embodiment, each row of cooling units 140 can include a row of heat exchangers 142 and a row of fans 144, such as above the heat exchangers 142. In at least one embodiment, the cooling units 140 can be or include condensers, dry coolers, cooling towers, or any combination thereof.

In at least one embodiment, any or all of the cooling units 140 can hingedly rotate and/or slide (horizontally and/or vertically) between the storage configuration and the deployed configuration, either individually or collectively in a group or array of two or more cooling units 140. In at least one embodiment, any or all of the cooling units 140 can hingedly rotate about one or more hinges 150. In at least one embodiment, any or all of the hinges 150 can be disposed along a proximate end of the second portion 114 of the container 110, adjacent the first portion 112 of the container 110, and/or at a distal end of the second portion 114 of the container 110, furthest from the first portion 112 of the container 110. In at least one embodiment, any or all of the hinges 150 can be disposed along a lower edge and/or an upper edge of the second portion 114 of the container 110 between the proximate end and the distal end of the second portion 114 of the container 110.

In at least one embodiment, any or all of the cooling units 140 can slide, horizontally and/or vertically, along one or more tracks or slides 160, which can be disposed adjacent corners of any or all rows of cooling units 140. In at least one embodiment, the slides 160 can elevate any or all of the cooling units 140, in the deployed configuration, and/or allow airflow into and/or under the cooling units 140, such as the heat exchangers 142 of the cooling units 140. In at least one embodiment, the slides 160 can expand/telescope and/or support any or all of the weight of the cooling units 140.

In at least one embodiment, a first portion of the cooling units 140 can hingedly rotate between the storage configuration and the deployed configuration and a second portion of the cooling units 140 can slide between the storage configuration and the deployed configuration. For example, as shown in the exemplary embodiment of FIGS. 12-14, a portion of the cooling units 140 can hingedly rotate between the storage configuration, where the cooling units 140 can be inverted within the second portion 114 of the container 110, and the deployed configuration, where the cooling units 140 can be rotated back above the first portion 112 of the container 110. As also shown in the exemplary embodiment of FIGS. 12-14, a portion of the cooling units 140 can slide, vertically, between the storage configuration and the deployed configuration.

In at least one embodiment, a first row of cooling units 140 can hingedly rotate in a first direction between the storage configuration and the deployed configuration and a second row of cooling units 140 can hingedly rotate in a second direction between the storage configuration and the deployed configuration. For example, as shown in the exemplary embodiment of FIGS. 15-17, one row of cooling units 140 can hingedly rotate in a clockwise direction between the storage configuration and the deployed configuration and another row of cooling units 140 can hingedly rotate in a counterclockwise direction between the storage configuration and the deployed configuration. As also shown in the exemplary embodiment of FIGS. 15-17, some or all of the cooling units 140 can slide, vertically, between the storage configuration and the deployed configuration.

In at least one embodiment, the cooling units 140 can be disposed within a footprint of the container 110 when in the storage configuration. In at least one embodiment, any or all of the cooling units 140 can remain within the footprint of the container 110 when in the deployed configuration and/or any or all of the cooling units 140 can extend beyond the footprint of the container 110 when in the deployed configuration. In at least one embodiment, a deployed footprint of the cooling units 140 in the deployed configuration can be the same as a storage footprint of the cooling units 140 in the storage configuration. As can be seen in the exemplary embodiment of FIGS. 12-14, all of the cooling units 140 can remain in a footprint of the container 110 when in the storage configuration and/or the deployed configuration.

In at least one embodiment, any or all of the cooling units 140 can extend beyond a footprint of the container 110, when in the deployed configuration. In at least one embodiment, a deployed footprint of the cooling units 140 in the deployed configuration can be larger than a storage footprint of the cooling units 140 in the storage configuration. In at least one embodiment, the deployed footprint of the cooling units 140 in the deployed configuration can be twice the storage footprint of the cooling units 140 in the storage configuration. For example, as can be seen in the exemplary embodiment of FIGS. 4-7, the cooling units 140 can extend on either side of a footprint of the container 110, and in the depicted example, the deployed footprint of the cooling units 140 in the deployed configuration can be twice the storage footprint of the cooling units 140 in the storage configuration. As can be seen in the exemplary embodiment of FIGS. 4-7, the footprint of the system 100 when the cooling units 140 are in the deployed configuration can be twice (such as at least approximately twice) the footprint of the container 110 when the cooling units 140 are in the storage configuration.

As can be seen in the exemplary embodiment of FIGS. 15-17, any or all of the cooling units 140 can extend at least partially beyond a footprint of the container 110, when in the deployed configuration, and in the depicted example, the deployed footprint of the cooling units 140 in the deployed configuration can be more than twice the storage footprint of the cooling units 140 in the storage configuration. As can be seen in the exemplary embodiment of FIGS. 15-17, the footprint of the system 100 when the cooling units 140 are in the deployed configuration can be more than twice the footprint of the container 110 when the cooling units 140 are in the storage configuration. In at least one embodiment, a first portion of the cooling units 140 can remain within a footprint of the container 110 when in the deployed configuration and a second portion of the cooling units 140 hingedly rotate and/or slide between the storage configuration and the deployed configuration, in which any or all of the second portion of the cooling units 140 can remain within the footprint of the container 110 and/or extend beyond the footprint of the container 110.

In at least one embodiment, the cooling units 140 need not be disconnected from the evaporator 130, once fluidically coupled thereto. In at least one embodiment, the cooling units 140 can remain fluidically coupled to the evaporator 130 when in the storage configuration, when in the deployed configuration, while transforming from the storage configuration to the deployed configuration, or any combination thereof. In at least one embodiment, the cooling units 140 can be fluidically coupled to the evaporator 130 through one or more flexible segments, such as one or more hoses, and/or one or more rotating joints. In at least one embodiment, the cooling units 140 and/or the evaporator 130 can be fully charged with refrigerant and tested, in terms of integrity and/or functionality, and then transformed to the storage configuration for storage and/or transportation, only to be retransformed on site fully functional and ready for operation without needing to be reconnected and/or recharged.

As can be seen in the exemplary embodiment of FIGS. 4-7, one or more rows of the cooling units 140 can be stored in the second portion 114 of the container 110. In at least one embodiment, such as upon being disposed at an installation location, one or more panels 116 can be removed from the second portion 114 of the container 110, exposing the rows of the cooling units 140. In at least one embodiment, the rows of the cooling units 140 can be folded, or rotated about hinges 150, downwardly, on either side of the container 110. In at least one embodiment, the rows of the cooling units 140 can be elevated, or can slide along slides 160, to an elevated position into the deployed configuration.

As can be seen in the exemplary embodiment of FIGS. 8-9, one or more rows of the cooling units 140 can be stored in the second portion 114 of the container 110. In at least one embodiment, such as upon being disposed at an installation location, one or more panels 116 can be removed from the second portion 114 of the container 110, exposing the rows of the cooling units 140. In at least one embodiment, the rows of the cooling units 140 can be folded, or rotated about hinges 150, upwardly, on either side of the container 110 to an elevated position into the deployed configuration.

As can be seen in the exemplary embodiment of FIGS. 10-11, one or more rows of the cooling units 140 can be stored in the second portion 114 of the container 110, such as in an alternating arrangement. In at least one embodiment, such as upon being disposed at an installation location, one or more panels 116 can be removed from the second portion 114 of the container 110, exposing the rows of the cooling units 140. In at least one embodiment, the rows of the cooling units 140 can be folded, or rotated about hinges 150, downwardly or upwardly (or both), on either side of the container 110 into the deployed configuration.

As can be seen in the exemplary embodiment of FIGS. 18-20, one or more rows of the cooling units 140 can be stacked in the second portion 114 of the container 110. In at least one embodiment, such as upon being disposed at an installation location, one or more panels 116 can be removed from the second portion 114 of the container 110, exposing the rows of the cooling units 140. In at least one embodiment, the rows of the cooling units 140 can be rotated outwardly from the storage configuration in different directions and/or at different angles (and/or slid/elevated) to the deployed configuration. In at least one embodiment, the cooling units 140 can be rotated about the hinges 150 at between zero and 90 degrees, between 90 degrees and 180 degrees, 90 degrees, 180 degrees, and any combination thereof, as can be seen in the exemplary embodiment of FIGS. 18-20.

In at least one embodiment, a method for deploying a data center or data center system according to the disclosure can include fluidically coupling one or more cooling units 140 to one or more evaporators 130 disposed within a container 110, and testing functionality and/or integrity of the cooling units 140, such as while the cooling units 140 are in a deployed configuration. In at least one embodiment, a method can include transforming the cooling units 140 from the deployed configuration to a storage configuration, such as while the cooling units 140 remain fluidically coupled to the evaporator 130. In at least one embodiment, the cooling units 140 can be disposed within the container 110 when in the storage configuration and/or exposed to an environment outside the container 110 when in the deployed configuration. In at least one embodiment, the method can include transforming the cooling units 140 from the storage configuration to the deployed configuration, while the cooling units 140 remain fluidically coupled to the evaporator 130. In at least one embodiment, transforming the cooling units 140 from the storage configuration to the deployed configuration can include moving at least some of the cooling units 140 from within a footprint of the container 110 to outside the footprint of the container 140.

In at least one embodiment, the method can include enclosing the cooling units 140 within the container 110, while in the storage configuration, and/or moving the container 110 to an installation location while the cooling units 140 are in the storage configuration and/or enclosed in the container 110. In at least one embodiment, the method can include, such as after moving the container 110 to the installation location, opening (and/or removing panels 116 from) at least a portion of the container 110, such as the second portion 114, while the cooling units 114 are in the storage configuration.

In at least one embodiment, a deployable data center system 100 according to the disclosure need not include any servers 120 and/or evaporators 130 and, for example, can include only one or more cooling units 140 (and associated equipment, if applicable). In such an embodiment, the system 100 can include one or more containers 110, and one or more cooling units 140 disposed within each container 110 for selectively rejecting heat from a cooling fluid to an environment outside of the containers 110. Furthermore, as discussed elsewhere in this disclosure, the one or more cooling units 140 of each container 110 can be arranged for being transformed from a storage configuration to a deployed configuration, such as wherein the cooling units 140 are disposed within the container 110 when in the storage configuration and wherein the cooling units 140 are exposed to the environment outside of the container 110 when in the deployed configuration. Each container 110 can be arranged for ready connection to one or more other components of a cooling system or cooling loop, such as one or more servers 120, evaporators 130, coolant distribution units (CDUs), or other components disposed within a building 170, such as a data center. For instance, each container 110, in addition to one or more deployable cooling units 140, can include any supporting equipment 180 required or desired according to a given implementation of the disclosure, such as fluid conduits, fluid connections, electrical power components, compressors, generators, valves, expansion valves, uninterruptable power supplies (UPSs), other equipment for supporting operation, or any combination thereof. In this manner, each container 110 can advantageously provide for readily deployable and/or modular cooling unit arrangements that can be efficiently installed at data centers and the like with minimal onsite assembly.

In at least one embodiment, a deployable data center system according to the disclosure can include one or more containers, and each container can include a plurality of cooling units configured to selectively reject heat from a cooling fluid to an environment outside of the container. The plurality of cooling units can be transformable from a storage configuration to a deployed configuration. The plurality of cooling units can be disposed within the container when in the storage configuration, and can be exposed to the environment outside of the container when in the deployed configuration.

In at least one embodiment, a deployable data center system according to the disclosure can include a container, one or more servers disposed in the container, at least one evaporator disposed in the container for transferring heat from the servers to a cooling fluid, a plurality of cooling units for rejecting heat from the cooling fluid to an environment outside of the container, or any combination thereof. In at least one embodiment, the container can have a plurality of sections or portions, such as a first portion, a second portion, and/or one or more other portions. In at least one embodiment, the servers and/or the evaporator can be disposed in the first portion of the container. In at least one embodiment, the cooling units can transform from a storage configuration to a deployed configuration. In at least one embodiment, the cooling units can be disposed within the second portion of the container and/or isolated from the environment, when in the storage configuration. In at least one embodiment, the cooling units can be exposed to the environment outside of the container, when in the deployed configuration. In at least one embodiment, the system can include one or more additional sections or portions, such as, for example, third, fourth, and/or other portions disposed adjacently or otherwise relative to first and second portions and/or one another. In at least one embodiment, the system can include one or more end sections or portions, such as for containing or otherwise supporting cooling equipment at one or more ends of a container.

In at least one embodiment, the container can be or include a standardized shipping container, such as those meeting ISO 668 promulgated by the International Organization for Standardization (ISO). For example, in at least one embodiment, the container can be 8 feet wide and either 40 feet or 45 feet long.

In at least one embodiment, the evaporator can be or include one or more air-to-fluid heat exchangers for extracting heat from air within the container, such as the first portion of the container. In at least one embodiment, the evaporator can be or include one or more direct-to-chip heat exchangers thermally coupled to the one or more of the servers. In at least one embodiment, the evaporator can include one or more fluid-to-fluid heat exchangers, such as brazed plate heat exchangers (BPHE), for extracting heat from the one or more direct-to-chip heat exchangers, such as through the cooling fluid and/or another cooling fluid.

In at least one embodiment, the plurality of cooling units can include one, two, or more rows of cooling units. In at least one embodiment, any or all of the cooling units can include at least one heat exchanger and at least one fan. In at least one embodiment, each row of cooling units can be or include at least one heat exchanger and a row of fans. For example, in at least one embodiment, each row of cooling units can include a row of heat exchangers and a row of fans, such as above the heat exchangers. In at least one embodiment, the cooling units can be or include condensers, dry coolers, cooling towers, or any combination thereof.

In at least one embodiment, any or all of the cooling units can hingedly rotate and/or slide (horizontally and/or vertically) between the storage configuration and the deployed configuration. In at least one embodiment, a first portion of the cooling units can hingedly rotate between the storage configuration and the deployed configuration and a second portion of the cooling units can slide between the storage configuration and the deployed configuration. In at least one embodiment, a first row of cooling units can hingedly rotate in a first direction between the storage configuration and the deployed configuration and a second row of cooling units can hingedly rotate in a second direction between the storage configuration and the deployed configuration.

In at least one embodiment, the cooling units can be disposed within a footprint of the container when in the storage configuration. In at least one embodiment, any or all of the cooling units can remain within the footprint of the container when in the deployed configuration and/or any or all of the cooling units can extend beyond the footprint of the container when in the deployed configuration. In at least one embodiment, a first portion of the cooling units can remain within a footprint of the container when in the deployed configuration and a second portion of the cooling units hingedly rotate between the storage configuration and the deployed configuration, in which any or all of the second portion of the cooling units can remain within the footprint of the container and/or extend beyond the footprint of the container. In at least one embodiment, a deployed footprint of the cooling units in the deployed configuration can be larger than a storage footprint of the cooling units in the storage configuration. In at least one embodiment, the deployed footprint of the cooling units in the deployed configuration can be twice the storage footprint of the cooling units in the storage configuration.

In at least one embodiment, the cooling units need not be disconnected from the evaporator, once fluidically coupled thereto. In at least one embodiment, the cooling units can remain fluidically coupled to the evaporator when in the storage configuration, when in the deployed configuration, while transforming from the storage configuration to the deployed configuration, or any combination thereof. In at least one embodiment, the cooling units can be fluidically coupled to the evaporator through one or more flexible segments, such as one or more hoses, and/or one or more rotating joints.

A method for deploying a data center according to the disclosure can include fluidically coupling one or more cooling units to one or more evaporators disposed within a container and testing functionality and/or integrity of the cooling units, while the cooling units are in a deployed configuration, and transforming the cooling units from the deployed configuration to a storage configuration, while the cooling units remain fluidically coupled to the evaporator. In at least one embodiment, the cooling units can be disposed within the container when in the storage configuration and/or exposed to an environment outside the container when in the deployed configuration. In at least one embodiment, the method can include transforming the cooling units from the storage configuration to the deployed configuration, while the cooling units remain fluidically coupled to the evaporator. In at least one embodiment, transforming the cooling units from the storage configuration to the deployed configuration can include moving at least some of the cooling units from within a footprint of the container to outside the footprint of the container.

In at least one embodiment, the method can include enclosing the cooling units within the container, while in the storage configuration, and/or moving the container to an installation location while the cooling units are in the storage configuration and/or enclosed in the container. In at least one embodiment, the method can include, such as after moving the container to the installation location, opening at least a portion of the container while the cooling units are in the storage configuration.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.
The disclosure comprises the following items:
1. A deployable data center system comprising:
   a container;
   a plurality of cooling units configured to selectively reject heat from a cooling fluid to an environment outside of the container;
   wherein the plurality of cooling units are configured to be transformed from a storage configuration to a deployed configuration;
   wherein the plurality of cooling units are disposed within the container when in the storage configuration; and
   wherein the plurality of cooling units are exposed to the environment outside of the container when in the deployed configuration.
2. The system as set forth in item 1, wherein the container has a first portion and a second portion, and further comprising:
   one or more servers disposed in the first portion of the container; and
   at least one evaporator disposed in the first portion of the container and configured to transfer heat from the one or more servers to the cooling fluid;
   wherein the plurality of cooling units are disposed within the second portion of the container when in the storage configuration.
3. The system as set forth in item 1 or item 2, wherein the container is at least 7 feet wide and at least 35 feet long.
4. The system as set forth in any preceding item, wherein the at least one evaporator includes one or more air-to-fluid heat exchangers configured to extract heat from air within the first portion of the container.
5. The system as set forth in any preceding item, wherein the at least one evaporator includes one or more direct-to-chip heat exchangers thermally coupled to the one or more servers.
6. The system as set forth in any preceding item, wherein the at least one evaporator includes one or more fluid-to-fluid heat exchangers configured to extract heat from the one or more direct-to-chip heat exchangers.
7. The system as set forth in any preceding item, wherein the cooling units are fluidically coupled to the at least one evaporator when in the storage configuration, when in the deployed configuration, and while being transformed from the storage configuration to the deployed configuration.
8. The system as set forth in any preceding item, wherein the cooling units are disposed within a footprint of the container when in the deployed configuration.
9. The system as set forth in any preceding item, wherein the cooling units are disposed at least partially beyond a footprint of the container when in the deployed configuration.
10. The system as set forth in any preceding item, wherein a first portion of the cooling units is disposed within a footprint of the container when in the deployed configuration, wherein a second portion of the cooling units is configured to rotate between the storage configuration and the deployed configuration, and wherein the second portion of the cooling units is disposed at least partially beyond the footprint of the container when in the deployed configuration.
11. The system as set forth in any preceding item, wherein the cooling units are configured to be hingedly rotated between the storage configuration and the deployed configuration.
12. The system as set forth in any preceding item, wherein the cooling units are configured to be slideably disposed between the storage configuration and the deployed configuration.
13. The system as set forth in any preceding item, wherein a first portion of the cooling units is configured to be hingedly rotated between the storage configuration and the deployed configuration, and wherein a second portion of the cooling units is configured to be slideably disposed between the storage configuration and the deployed configuration.
14. The system as set forth in any preceding item, wherein at least a portion of the cooling units is configured to be hingedly and slideably moved between the storage configuration and the deployed configuration.
15. The system as set forth in any preceding item, wherein the cooling units are isolated from the environment when in the storage configuration.
16. The system as set forth in any preceding item, wherein a deployed footprint of the cooling units in the deployed configuration is at least twice the area of a storage footprint of the cooling units in the storage configuration.
17. The system as set forth in any preceding item, wherein the plurality of cooling units includes at least two rows of cooling units.
18. The system as set forth in any preceding item, wherein each row of cooling units includes at least one heat exchanger and a row of fans.
19. The system as set forth in any preceding item, wherein each row of cooling units includes a row of heat exchangers and a row of fans.
20. The system as set forth in any preceding item, wherein a first row of cooling units is configured to be hingedly rotated in a first direction between the storage configuration and the deployed configuration, and wherein a second row of cooling units is configured to be hingedly rotated in a second direction between the storage configuration and the deployed configuration.

## Claims

1. A deployable data center system comprising:
a container;
a plurality of cooling units configured to selectively reject heat from a cooling fluid to an environment outside of the container;
wherein the plurality of cooling units are configured to be transformed from a storage configuration to a deployed configuration;
wherein the plurality of cooling units are disposed within the container when in the storage configuration; and
wherein the plurality of cooling units are exposed to the environment outside of the container when in the deployed configuration.

2. The system as set forth in claim 1, wherein the container is at least 2 metres wide and at least 11 metres long.

3. The system as set forth in claim 1 or claim 2, wherein the container has a first portion and a second portion, and further comprising:
one or more servers disposed in the first portion of the container; and
at least one evaporator disposed in the first portion of the container and configured to transfer heat from the one or more servers to the cooling fluid;
wherein the plurality of cooling units are disposed within the second portion of the container when in the storage configuration.

4. The system as set forth in claim 3, wherein the at least one evaporator includes one or more air-to-fluid heat exchangers configured to extract heat from air within the first portion of the container.

5. The system as set forth in claim 3 or claim 4, wherein the at least one evaporator includes one or more direct-to-chip heat exchangers thermally coupled to the one or more servers, and optionally wherein the at least one evaporator includes one or more fluid-to-fluid heat exchangers configured to extract heat from the one or more direct-to-chip heat exchangers.

6. The system as set forth in any of claims 3-5, wherein the cooling units are fluidically coupled to the at least one evaporator when in the storage configuration, when in the deployed configuration, and while being transformed from the storage configuration to the deployed configuration.

7. The system as set forth in any preceding claim, wherein the cooling units are disposed within a footprint of the container when in the deployed configuration.

8. The system as set forth in any of claims 1-6, wherein the cooling units are disposed at least partially beyond a footprint of the container when in the deployed configuration, and optionally wherein a deployed footprint of the cooling units in the deployed configuration is at least twice the area of a storage footprint of the cooling units in the storage configuration.

9. The system as set forth in any of claims 1-6, wherein a first portion of the cooling units is disposed within a footprint of the container when in the deployed configuration, wherein a second portion of the cooling units is configured to rotate between the storage configuration and the deployed configuration, and wherein the second portion of the cooling units is disposed at least partially beyond the footprint of the container when in the deployed configuration.

10. The system as set forth in any preceding claim, wherein the cooling units are configured to be hingedly rotated between the storage configuration and the deployed configuration.

11. The system as set forth in any preceding claim, wherein the cooling units are configured to be slideably disposed between the storage configuration and the deployed configuration.

12. The system as set forth in any of claims 1-9, wherein:
a first portion of the cooling units is configured to be hingedly rotated between the storage configuration and the deployed configuration, and wherein a second portion of the cooling units is configured to be slideably disposed between the storage configuration and the deployed configuration; or
at least a portion of the cooling units is configured to be hingedly and slideably moved between the storage configuration and the deployed configuration.

13. The system as set forth in any preceding claim, wherein the cooling units are isolated from the environment when in the storage configuration.

14. The system as set forth in any preceding claim, wherein the plurality of cooling units includes at least two rows of cooling units, and optionally:
wherein each row of cooling units includes at least one heat exchanger and a row of fans; or
wherein each row of cooling units includes a row of heat exchangers and a row of fans.

15. The system as set forth in claim 14, wherein a first row of cooling units is configured to be hingedly rotated in a first direction between the storage configuration and the deployed configuration, and wherein a second row of cooling units is configured to be hingedly rotated in a second direction between the storage configuration and the deployed configuration.
